Europäisches Patentamt

European Patent Office

Office européen des brevets

(11) Publication number: **0 381 381**
**A2**

# EUROPEAN PATENT APPLICATION

(21) Application number: **90300799.5**

(22) Date of filing: **25.01.90**

(51) Int. Cl.⁵: **H05K 7/10, H01R 23/68**

(30) Priority: **27.01.89 GB 8901819**

(43) Date of publication of application:
**08.08.90 Bulletin 90/32**

(84) Designated Contracting States:
**DE ES FR GB IT NL**

(71) Applicant: **STAG MICROSYSTEMS LTD.**
**Martinfield**
**Welwyn Garden City, Hertfordshire AL7 1JT(GB)**

(72) Inventor: **Howell, Elgan Neville**
**13 Lodge Drive**
**Hatfield, Herts.(GB)**
Inventor: **Gilbert, Ian David**
**25 Carlisle Avenue**
**St. Albans, Herts.(GB)**
Inventor: **Humphreys, Chris**
**62 Dudley Road**
**Walton-on-Thames, Surrey(GB)**

(74) Representative: **Hale, Peter et al**
**Kilburn & Strode 30 John Street**
**London WC1N 2DD(GB)**

(54) Universal electrical contact.

(57) A multi-element electrical contact comprises rows of elements arranged about a datum about which each of a range of different sized electronic device packages (e.g. PLCC or LCC) are positionable to establish electrical contact with the elements. At least some of the elements (40a,40b) in at least one row extend in a direction in which a corresponding dimension of the packages varies to accommodate for the different positions of contact between the terminals on the packages and the contact elements.

Fig.2

# UNIVERSAL ELECTRICAL CONTACT

This invention relates to electrical contacts. The invention is particularly applicable to universal contacts for making electrical contact with various electronic device packages from a range of similar packages.

Electronic devices of all types are variously tested and/or programmed before being attached to a circuit board by soldering or some other means. When testing and/or programming these devices, it is desirable to employ a means of temporary connection which are both simple to manufacture and operate, as well as being reliable.

In the case of dual-in-line (DIL) electronic device packages, temporary connectors are known in which the standard spacing between two parallel rows of pin terminals or legs associated with the package is exploited. Each of a broad range of such DIL device packages can be clamped in a temporary connector having two suitably spaced parallel rows of jaws which bite on the legs when the legs are inserted. These connectors can accept different lengths of DIL package up to a maximum defined by the length of the connector so long as the packages are all of the same width.

Thus, a multi-element contact is known which comprises a plurality of electrically conductive elements for electrical connection to each of a range of differently sized electronic device packages, the device packages having different numbers of similarly spaced electrically conductive terminals, each of the elements being arranged to establish respective electrical contact with a terminal of at least one of the range of device packages.

In the case of surface mount devices (SMD), e.g. plastics leadless chip carrier or leadless chip carrier (PLCC or LCC) devices or Quad flat pack devices (QFP) and small outline integrated circuits (SOIC), the configuration of pins (or "pin out") while standard in terms of the spacings between pins is not susceptible to the DIL solution as the groups of pins are arranged on four sides of a rectangle, typically (though not always) a square, which may be of any one of a number of sizes.

If a range of SMD package sizes are to be tested or programmed on a single instrument, several problems arise. Firstly, up to now a dedicated socket for each size of package has been required. Thus, any instrument designed to take more than one size of SMD package will have a size and cost largely dependent on how versatile the instrument is to be.

Secondly, particularly for testing and measurement, the use of multiple sockets can give slightly different measured electrical parameter values for each different socket due to different lengths of connecting leads leading to the test or measurement instrument. As testing and measurement speeds increase dramatically the problems associated with inherent resistance, capacitance and inductance in such leads become more acute.

While it is an object of the present invention to provide an electrical contact or matrix of contacts which can accommodate different sizes of SMD package it is also possible to extend the solution to other types of pin-out arrangement having two or more groups of terminals for which a single versatile socket is required. In the specification the word "universal" is used to refer to contacts which are able to accept two or more device packages, i.e. two different sizes of similar packages or two different types of package. for example DIL, PLCC or LCC configurations.

The present invention is characterised in that each of a selection of the elements is connectable with a terminal of each of two or more of the device packages of the range correctly positioned with respect to a common datum, the points of connection being made along elongate tracks arranged to accommodate the different locations of the points of connection between that element and the contacting terminal of each of the said device packages from the range.

Preferably the elongate tracks extend in parallel along the direction of the dimension or dimensions in which the spacing between the groups varies.

In one particularly preferred form, the invention is designed for packages having terminals on four rectangularly arranged sides such as the PLCC and LCC packages previously mentioned. The corresponding four groups of electrically conductive elements comprise at least two adjacent groups, corresponding to the two sides of a rectangle of each package, which groups consist of elongate tracks. The other two adjacent groups may be similarly elongate tracks for the same purpose. In this case the device package is orientated about a central point. However, it is also possible to align the device package along two edges of the package so that two of the groups of terminals of each package in the range engage the elements in substantially the same position. In this case these elements need not be elongate, but simply spaced to register with those terminals aligned along the two edges. In this case, the elements constituted by the elongate tracks in the remaining two groups each extend normally to an opposite aligned edge.

The invention also extends to a connector including a multi-element contact, a common mount for each of the range of device packages, positioning means for maintaining the position of each package on the mount with respect to the datum, and means for urging the contact elements into contact with the terminals. Preferably, guide means guide the elements into engagement with the terminals.

Preferably, the positioning means comprise a V-shaped abutment arranged to engage two edges of the device package.

Alternatively, the positioning means comprise a recess defining a series of ledges each adapted to receive one of the sizes of device package.

Preferably, the guide means are hingedly attached to the mount. In this case the guide means may be a cover to which the contact is secured.

Preferably, a projection is mounted on the guide means which is arranged to hold the device package received in the positioning means in place as the elements of the contact are brought into engagement with the terminals.

In one form the connector is provided with at least two sets of contacts corresponding to two different package styles and ranges.

The invention also extends to devices having groups of terminals in different planes. The device may be a hexahedron, e.g. a cube. The pattern of elements may be replicated on two adjacent surfaces, with the abutting edges serving as a datum.

It is also possible to provide a contact for a circular package in which the terminals are angularly spaced around the periphery of the package. In this case the tracks would have to extend radially from the centre. As the circumference of the package increased sufficiently to accommodate extra terminals, so further elements would begin substantially at that radius with respect to the central point of orientation and radiate from there.

The present invention can be put into practice in various ways some of which will now be described by way of example with reference to the accompanying drawings in which:

Figure 1 is a section through a connector according to the present invention;

Figure 2 illustrates the arrangement of elements in the connector of Figure 1;

Figure 3 illustrates an alternative form of the present invention;

Figure 4 illustrates the arrangement of elements for the connector of Figure 3;

Figure 5 is a section through another embodiment of the invention;

Figure 6 illustrates a further embodiment of the invention;

Figure 7 is a section through the connector of Figure 6;

Figure 8 is a section through a still further embodiment of the invention;

Figure 9 is a perspective view of the embodiment of Figure 8; and

Figure 10 is a section through a modified form of the embodiment of Figures 8 and 9.

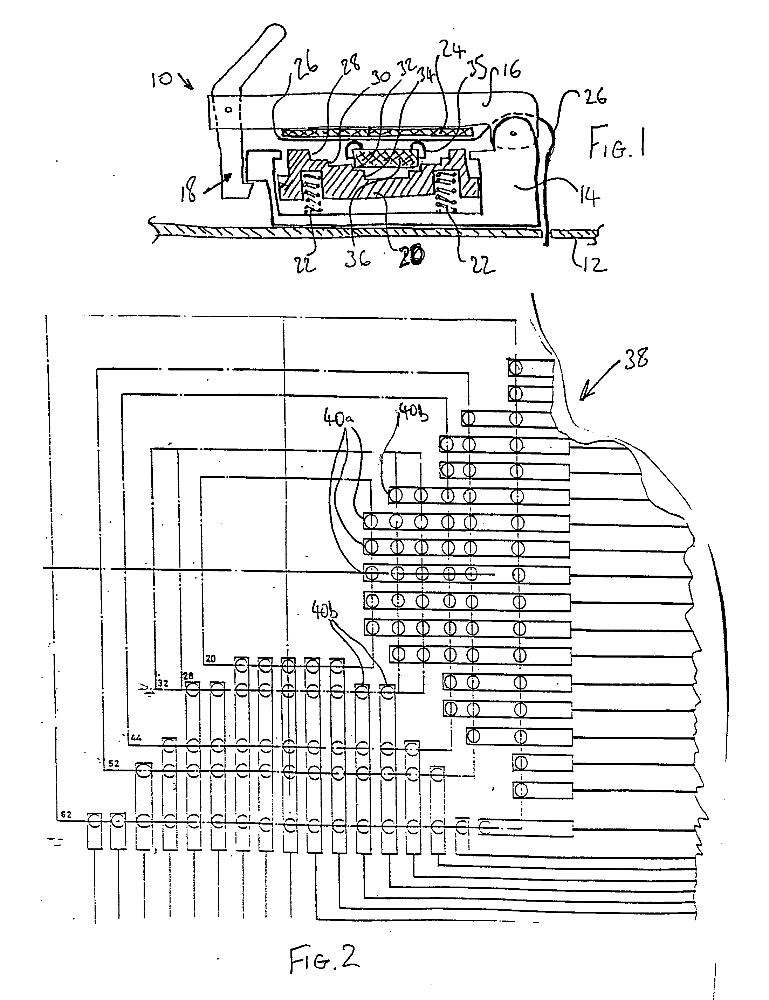

Referring to Figures 1 and 2 of the drawings, a connector 10 is mounted on a support 12. The connector 10 comprises a mounting block 14 having a hinged cover 16 which is securable to close the block by means of a catch arrangement 18.

A floating position plate 20 is received within a recess in the mounting block 14 as a close tolerance fit. The plate 20 floats on four spaced springs 22 bearing on the base of the recess in the block 12 which are located in recesses in the underneath of the plate 20. A resilient rectangular foam backing pad 24 is attached to the surface of the lid 16 opposite the floating position plate 20 when the lid is closed. A flexible printed circuit conductor 26, comprising a non-conductive plastics foil, e.g. polyimide, having a metal layer on it which is etched to define the electrically conductive contacts 38 and paths, is attached to the surface of the backing pad 24. The flexible conductor 26 extends sideways between the cooperating parts of the hinge connection between the block 14 and the lid 16 and away for electrical connection to, for example, a piece of test or measurement apparatus.

The floating position plate 20 is formed with a series of progressively shallower and wider peripherally rectangular concentric alignment recesses 28, 30, 32 and 34. Each alignment recess 28, 30, 32 or 34 is dimensioned to accept, as a close tolerance fit, the body of a standard size PLCC package 36 from a range of such package sizes all in the same centrally aligned orientation. To establish electrical contact between the terminals or pins 35 of a chosen electronic device package 36 and the electrically conductive contacts 38 of the flexible conductor 26, the package is simply placed in the appropriate recess with the pins facing upwards and the lid is then closed to bring the elements 38, urged by the resilient backing pad 24, to bear on the pins. This will also cause the floating position plate 20 to be depressed slightly on the springs 22 in order to accommodate any planar misalignment between the pins and the contacts 38 of the printed circuit conductor.

Referring particularly to Figure 2, the pattern of electrically conductive contacts 38 is shown. However, for the sake of clarity only two of the four groups of elements are specifically illustrated. It will be appreciated by the skilled person that the remaining two groups are a mirror image of the two groups shown.

Each group comprises of a plurality of electrically conductive parallel tracks 40. In this particular embodiment the connector is designed to accept five different sizes of rectangular, commonly square, PLCC package. Disposed on each side there are five central tracks 40a extending outwardly over the positions of the corresponding pins 35 of the group of pins on that side. The length of the tracks is sufficient to cover the locations of contact of the terminals of the aligned packages for all the five sizes. The smallest device package contacted by the four groups of five contacts alone has 20 pins, as indicated by the circles in Figure 2 on the innermost chain dotted line, which line is an indication of the contact position of that device package.

Progressing outwardly from the inner five tracks 40a in each group, they are supplemented by an additional one or two elongate tracks 40b on either side. The radially inner end of the additional tracks are coincident with the positions of a centrally aligned package having 28 or 32 pins as indicated by the circles and chain dotted lines. In the case of the 28 pin package, the outermost tracks of the two of the nine track groups are not contacted by the adjacent pins on the package.

Additional tracks are added coincident with each package size corresponding to 44, 52 and 62 pin package sizes. Again, these are indicated by the circles and chain dotted lines in Figure 2. Thus, a package of any of the correct dimensions is centrally aligned with the correct set of tracks by means of its corresponding recess and will be orientated for electrical connection with the appropriate set of electrically conductive contacts according to its dimension.

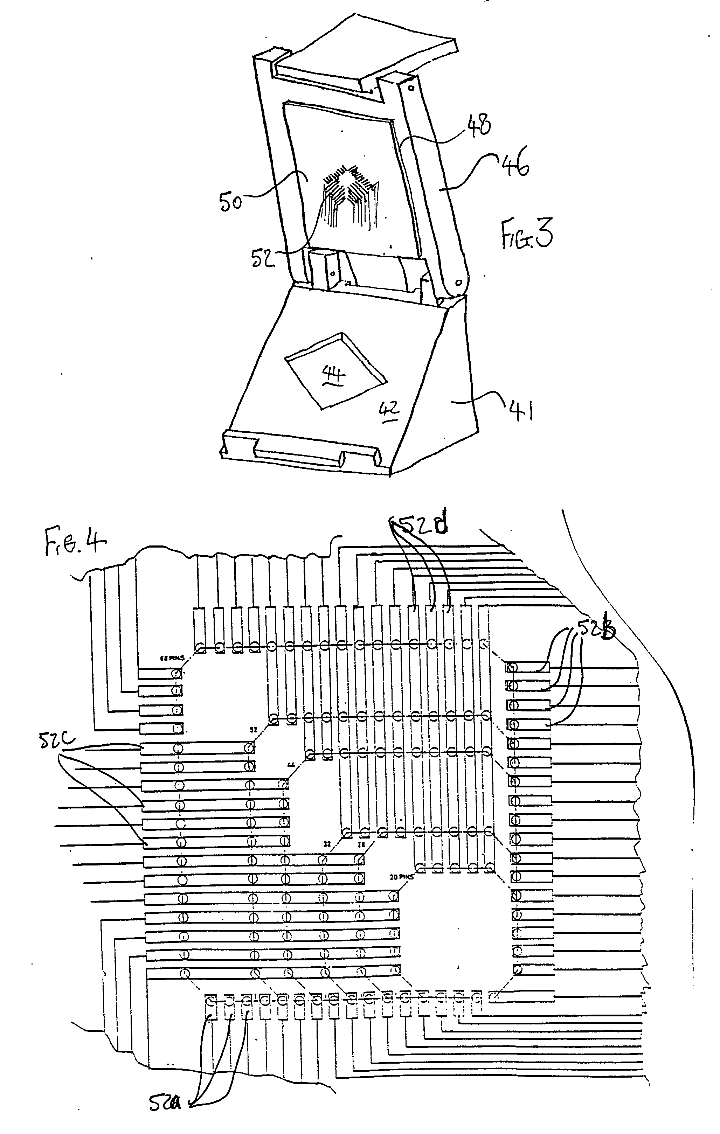

Figures 3 and 4 illustrate an alternative embodiment in which a temporary connector block comprises a base 41 having a front face 42 set at 45 degrees to the horizontal. The front face 42 is formed with a square sided recess 44 which is large enough to receive the range of SMD device packages referred to previously. The block also has a cover 46 which is similar to that illustrated in Figure 1, having a resilient foam backing pad 48 on which is mounted a printed circuit conductor 50 having conductive tracks 52 and paths.

The complete pattern of the conductor is illustrated in detail in Figure 4. In this embodiment the device package is aligned along two adjacent sides by placing the package into the recess 44 so that it falls into the V-shape cleft defined by the lowermost adjacent walls. This gravity-assisted edge alignment of the device package ensures that the terminals on the two lower most sides of the package are in registry with the adjacent two groups of short contacts 52 a and b.

The parallel tracks 52 c and d corresponding to the opposite two sides of one of the range of packages, extend outwardly along the direction in which each respective dimension varies. The inner end of the first five of the tracks extend most inwardly to accommodate the smallest square package of 20 pins. These are contacted together with the five tracks on each side of the base of the V-shaped cleft to establish electrical contact.

Similarly, the 28 pin package is accommodated by the first seven tracks of each side. The further two elements required of the tracks 52 c and d extend outwardly parallel to the first five longest tracks, starting at a position corresponding to the location of the pins in that size of package.

Two additional vertical tracks 52c are added to the tracks corresponding to the 28 pin configuration to take account of the size of package having 32 pins.

Thus, when the cover 46 is closed the pins of each size of package are connected with a sufficient number of conducting tracks 52 at points along the length and/or generally towards the ends of the tracks.

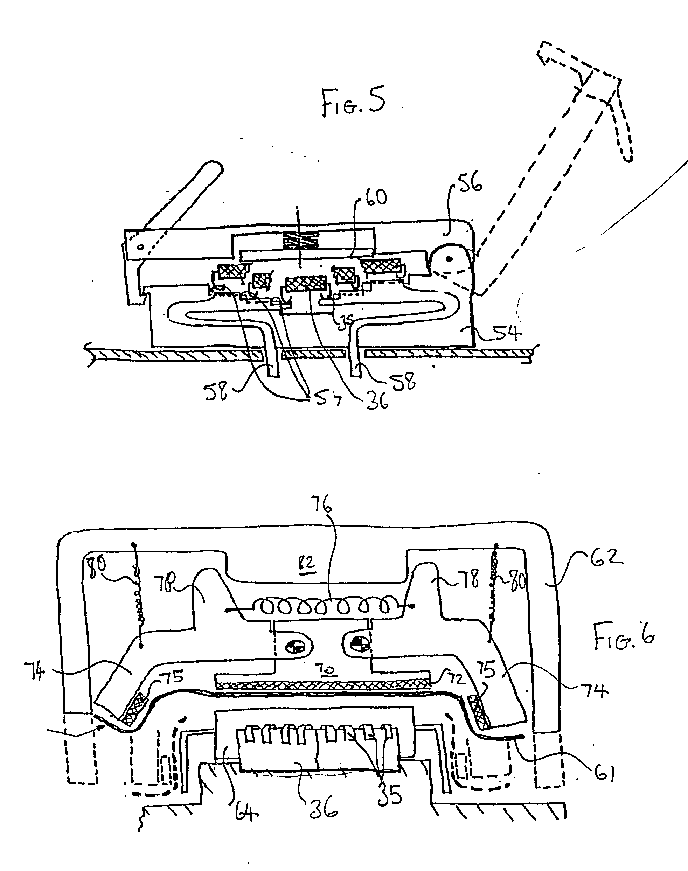

Figure 5 illustrates an alternative form of the invention which uses conventional sprung contacts. The connector has a mounting block 54 to which is hingedly attached a cover 56. The mounting block 54 is formed with concentric rectangular recesses 57 in the same manner as Figure 1. However, the mounting block also accommodates a plurality of sprung contacts 58 configured according to the pattern of Figure 2. The lid is provided with a spring mounted pressure plate 60 which urges a SMD device 36 mounted in its recess, with its pins 35 facing downwardly, against the contacts. Here the recesses are dimensioned to align the device packages according to the outer dimension including the pins 35.

Figure 6 discloses a further embodiment of the connector which is applicable to both PLCC devices and DIL devices.

A mounting block 68 supports the SMD device 36 with its pins 35 uppermost and exposed to make contact with electrically conductive elements on a flexible printed circuit 61 attached to a cover 62 or a DIL device 64 arranged with its legs 66 directed downwardly, straddling a mounting block 68 on which the SMD device 36 is aligned. The cover 62 has a centrally mounted padblock 70 which projects towards the device under test when the cover 62 is closed. The padblock 70 is provided with a resilient foam pad 72 on which is secured the flexible printed circuit 68 which is similar to that in Figure 2. However, in this case, the flexible printed circuit is also printed with contacts 71 corresponding to the spacing for the two groups of pins on a DIL package 64.

Hingedly mounted on either side of the padblock are jaws 74 which are biased to an open position by a tension spring 76 attached to a lever projection 78 on each jaw 74. A return spring 80 is also attached between the cover 62 and each jaw 74. The printed circuit is attached to a foam pad 75 on each jaw corresponding to the area of the jaw which is pressed against the pins of the device 64.

When the cover 62 is open the springs hold the jaws raised above the mounting block 68. By closing the cover 62 on to a SMD device mounted inverted in an aligned position on the block 68, the conductor tracks printed on the flexible circuit 61 contact the pins 35 of the SMD device package.

Alternatively, the DIL device package 64 can be placed over the mounting block 68 as described previously. One edge is positioned abutting a shoulder 69 at one end of the mounting block 68 remote from the hinge to position it. The package is thus aligned to make contact with the similarly spaced contacts on the printed circuit which is wrapped around the DIL device package 64 as the cover 62 is closed and the jaws 74 close. The jaws 74 are urged into a closed position around the DIL package by the engagement of the projections 78 with a central boss 82 in the manner of a camming action. This urges the jaws 74 inwardly as the cover 62 is pressed home, pushing the DIL contacts 71 into engagement with the terminal legs on the device package 64.

The cover 62 is held in the closed position with the contacts engaging the pins of either the SMD or DIL package by means of a catch arrangement similar to that illustrated in Figure 1.

Figure 7 shows the arrangement of the cover in Figure 6. However, in this embodiment the mounting block 86 is orientated at an angle of 45 degrees to the horizontal. Thus, the alignment of either the DIL or PLCC package is again assisted by gravity as either it is caused to fall against the shoulder 69, or the cleft of the V-shape edges, respectively.

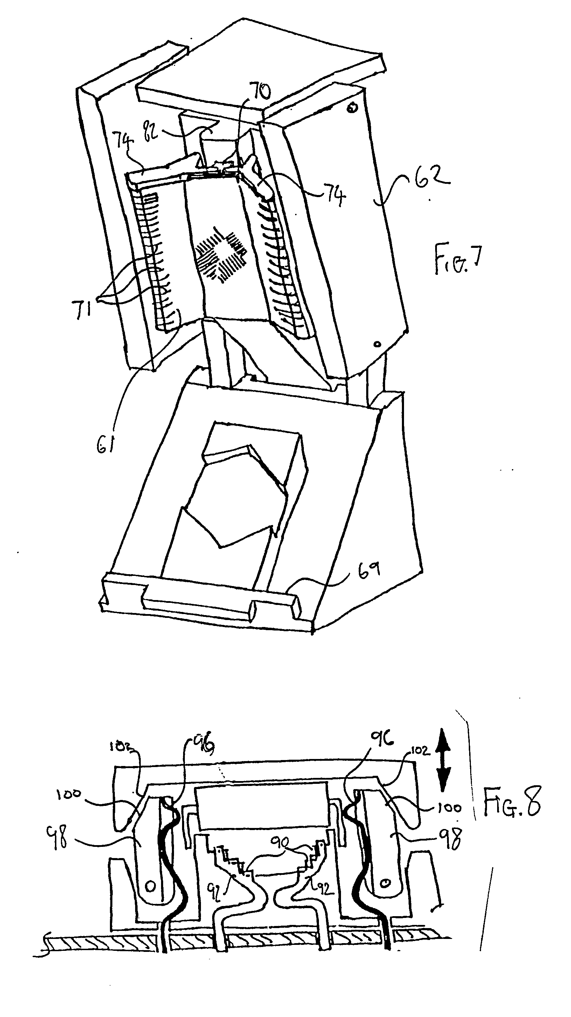

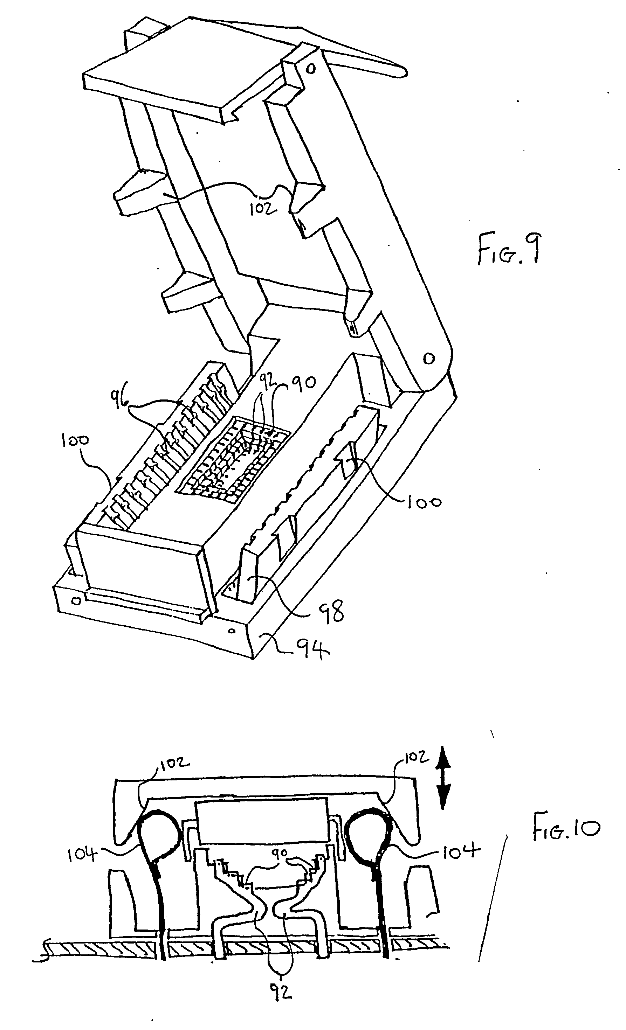

Figures 8 and 9 illustrate a further embodiment of the invention in which the SMD contacts are again developments of the conventional spring arrangement. Here, the connector has the series of centrally aligning recesses 90, as illustrated in Figure 1. However, the contacts are formed from resilient metal members 92 mounted inside the mounting block 94 and projecting upwardly through recesses in the block corresponding to the spacing of the pins on the PLCC device package. The exposed contact surface of each member 92 is stepped in sympathy with the stepping created by the recesses.

The connector is also designed to accept DIL as well as SMD device packages. Spring contacts 96 are urged toward the DIL pins by means of cam actuated hinged contact holders 98. Each holder 98 has a chamfered end 100 arranged to be engaged by a complementarily formed face 102 on the inside of each of the sides of the cover. As before, closing of the cover effects connection between the pins of the DIL device package or ensures contact is maintained between the PLCC device package and its contacts.

Figure 10 illustrates a further modification of the connector in Figure 8. In this case the sprung cam actuated DIL contacts are replaced by sprung contacts having integral loops 104 which also serve as the means by which the contact engages the chamfered face 102 of the cover by which each contact is urged into engagement with a respective DIL contact leg. As with previous examples, the cover is securable in the closed position by means of a catch arrangement mounted on a cover which engages a lip on the base.

It will be understood that the invention is not restricted to rectangularly shaped device packages. There can be benefits, particularly in terms of the density of terminals, in configuring the terminals in a radial pattern on a circular device package. In this case, the contacts on the connector may be constituted by a radial pattern of elongate tracks extending from a common point. In this case, the circular packages may be of different diameters. The device should both be centrally aligned and the tracks added to to radiate outwardly from an appropriate radius with respect to the central point to cater for more contacts being added as the diameter of the device packages increase.

Furthermore, other straight sided shapes could be accommodated by using elongate tracks according to the present invention.

In another form of the invention the tracks are constituted by grooves or channels in a body along which pin contacts are movable. The pattern of the track grooves accord with the invention. A device is positioned in a receiving recess and the pins moved inwardly along the tracks towards the SMD terminals to make electrical contact. It will be appreciated that this arrangement is particularly applicable to temporary connection for test purposes and the like.

It will also be understood that the invention is not restricted to temporary connections for programming or testing use but can be implemented in simplified form for more permanent designs where versatile and regular component access is required.

It will further be understood that the invention can also be implemented to provided interchangability between one or more devices of similar electrical function but different package styles, e.g. DIL to PLCC.

It is further understood that the invention includes contacts for devices with asymmetric and/or non-planar contacts.

## Claims

1. A multi-element electrical contact comprising a plurality of electrically conductive elements (40) for electrical connection to each of a range of differently sized electronic device packages (36), the device packages having different numbers of similarly spaced electrically conductive terminals (35), each of the elements being arranged to establish respective electrical contact with a terminal of at least one of the range of device packages, characterised in that each of a selection of the elements is connectable with a terminal of each of two or more of the device packages of the range correctly positioned with respect to a common datum, the points of connection being made along elongate tracks arranged to accommodate the different locations of the points of connection between that element and the contacting terminal of each of the said device packages from the range.

2. A contact as claimed in claim 1 in which each of the accommodating elements is constituted by an electrically conductible elongate track (40a,40b,52c,52d).

3. A contact as claimed in claim 1 or 2 in which the elements are grouped in rows, each elongate track extending along a direction normal to a corresponding row.

4. A contact as claimed in claim 3 in which at least one group comprises a first set of elongate tracks (40a,52d), each respectively registrable with each of a corresponding number of terminals of each device package in the range, and at least a second set of shorter tracks (40b,52c), each respectively registrable with each of a corresponding number of terminals of each of a selection of device packages from the range.

5. A contact as claimed in claim 3 or 4 in which the inner ends of the elements substantially define the four sides of a rectangle generally corresponding to the dimensions of the smallest device package in the range.

6. A contact as claimed in claim 2, 3, 4 or 5 in which each row of elements also comprises elements (52a) registrable with only the terminals of the largest or smallest device package in the range.

7. A contact as claimed in claim 2, 3, 4 or 5 arranged to connect a range of SMD packages (36).

8. A contact as claimed in any preceding claim in which the elements are flexible and are mounted on a flexible substrate.

9. A contact as claimed in claim 8 in which the substrate is mounted on a resilient backing (24)

10. A connector including a multi-element contact as claimed in any preceding claim, a common mount (20,42) for each of the range of device packages, positioning means (28,30,32,34) for maintaining the position of each package on the mount with respect to the datum, and means for urging the contact elements into contact with the terminals.

11. A connector as claimed in claim 10 in which the positioning means (44) are mounted in an inclined attitude on a base (41)

FIG. 1

FIG.2

Fig.3

Fig.4

Fig. 5

Fig. 6

Fig. 7

Fig. 8

Fig. 9

Fig. 10